(19) Europäisches Patentamt
European Patent Office
Office européen des brevets

(11) Publication number: **0 138 963 B1**

(12) # EUROPEAN PATENT SPECIFICATION

(45) Date of publication of patent specification: **25.05.88**

(51) Int. Cl.⁴: **H 01 L 21/205,** H 01 L 29/207

(21) Application number: **84901513.6**

(22) Date of filing: **15.03.84**

(86) International application number:
**PCT/US84/00399**

(87) International publication number:
**WO 84/03995 11.10.84 Gazette 84/24**

(54) **DIETHYLBERYLLIUM DOPANT SOURCE FOR MOCVD GROWN EPITAXIAL SEMICONDUCTOR LAYERS.**

(30) Priority: **04.04.83 US 482091**

(43) Date of publication of application:
**02.05.85 Bulletin 85/18**

(45) Publication of the grant of the patent:
**25.05.88 Bulletin 88/21**

(84) Designated Contracting States:
**BE CH DE FR GB LI NL SE**

(56) References cited:
**Journal of the Electrochemical Society, vol. 130, no. 8, August 1983 J.D. Parsons et al.: "Use of diethylberyllium for metal organic chemical vapor deposition of beryllium-doped gallium arsenide" 1782-1783**
**Proceedings of the ESSDERC-SSSDT solid state devices 1982 Meeting, 13-16 September 1982, A. Goetzberger et al. (Weinheim, DE) J. Hallais: "Metal organic vapour phase epitaxy: the key issues", 51-72**

(73) Proprietor: **Hughes Aircraft Company**
**7200 Hughes Terrace P.O. Box 45066**
**Los Angeles California 90045-0066 (US)**

(72) Inventor: **PARSONS, James, D.**
**596 Strauss Drive**
**Newbury Park, CA 91320 (US)**

(74) Representative: **Colgan, Stephen James et al**
**CARPMAELS & RANSFORD**
**43 Bloomsbury Square**
**London WC1A 2RA. (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 138 963 B1

**Description**

Technical field

The present invention generally relates to the chemical vapor deposition (CVD) growth of doped epitaxial semiconductor layers, and, in particular, to the use of diethylberyllium (DEB) as a dopant source in metal organic chemical vapor deposition (MOCVD) reactor systems to permit the growth of beryllium-doped epitaxial compound and compound alloy semiconductor layers.

Background of the invention

The metal organic chemical vapor deposition technique is generally known as permitting the epitaxial growth of semiconductor layers on the surface of an appropriate substrate. The technique permits the growth of a uniform epitaxial layer having a controlled thickness within the range of approximately 100Å to greater than several micrometers over an area equal to that of conventional semiconductor substrates. While the most common application of MOCVD is to provide gallium arsenide (GaAs) epitaxial layers on the surface of a GaAs substrate, the MOCVD technique is not necessarily so limited. The technique generally involves the provision of any number of vapor phase metal alkyl and hydride compounds in close proximity to a heated substrate surface. The temperature is closely controlled so as to be appropriately above the decomposition temperature of the alkyl and hydride compounds such that they decompose permitting the respective metal/semiconductor compounds to further react and deposit as a compound semiconductor material layer on the surface of the substrate. The remaining organic fractions further react to form highly volatile, noncontaminating vapor phase compounds that are easily removable from the general proximity of the substrate. For the formation of a GaAs epitaxial layer, trimethylgallium (TMG) and arsine are typically used. The ideal reaction proceeds as shown below:

$$(CH_3)_3Ga+AsH_3 \xrightarrow[\Delta]{H_2 \text{ carrier}} GaAs\downarrow +3CH_4.$$

Additional alkyls, such as trimethylaluminum, and hydrides, such as phosphine, may be employed to form compound and compound alloy epitaxial layers having a desired composition analogous to $Al_xGa_{1-x}As_yP_{1-y}$, where x and y may vary independently between 0 and 1. Further, alkyl and hydride compounds may be appropriately selected so that the deposited elemental reactant fraction dopes the epitaxial layer to a desired carrier concentration and conductivity type. In the growth of a GaAs epitaxial layer, a p-type conductivity can be obtained by the deposition of a zinc dopant provided by the decomposition of dimethylzinc. Correspondingly, an n-type conductivity can be obtained by the deposition of a sulfur dopant provided by the decomposition of hydrogen sulfide.

There are substantial and highly desirable applications for semiconductor devices fabricated using, inter alia, successive depositions to produce a series of epitaxial layers. There are further advantages that can be obtained by having abrupt or precisely graded junctions between the layers and by further providing a precise concentration of a dopant to realize a particular conductivity type, carrier concentration, and dopant profile. In practice, however, a number of interrelated problems have prevented the fabrication of such a succession of doped epitaxial layers. The principal problem involves identifying a dopant species that can be suitably transported as a vapor-phase metal-organic compound into close proximity to the substrate. A number of potential dopants, such as silver, simply fail to form a useful metal-organic compound.

Another problem is that, following the decomposition of the metal-organic compound, the dopant may fail to either physically or electrically incorporate into the growing epitaxial layer. The failure to physically incorporate into the layer results in a phenomenon generally known as "surface pile-up". This phenomenon is attributed to a kinetics interaction between the various materials present at the growth surface of the epitaxial layer. The dopant species is constantly supplanted from lattice sites immediately beneath the growth surface as the deposition process proceeds. Consequently, the underlying epitaxial layer is left effectively undoped.

Failure of the dopant species to electrically incorporate is largely the result of the dopant species having a highly amphoteric characteristic in the particular semiconductor growth material. An amphoteric dopant, as is generally well-known, has a propensity to fill vacancies within the semconductor lattice as both a donor and acceptor. A highly amphoteric dopant has a donor-type to acceptor-type vacancy fill ratio that approaches unity. This ratio is also known as the ratio of self-compensation and is an indication of the degree to which the dopant fails to be electrically active as a dopant of a particular conductivity type and, thereby, contribute to the carrier concentration within the layer.

Another problem with the MOCVD growth of precisely doped eptiaxial layers involves the use of a metal-organic transport compound that effectively contaminates either the reactor system or the substrate. The transport compound must be such that it remains in the vapor phase until it is in close proximity to the substrate. Condensation onto and subsequent evaporation from tube walls within the reactor system results in delayed, and therefore improper, doping of subsequently grown epitaxial layers. This further results in an unpredictable dopant grading of the epitaxial layer as well as the junction between the growing layer and the previous layer. This improper delayed-doping is generally referred to as the "memory-effect" phenomenon.

The dopant transport compound must also have a reasonably narrow decomposition temperature

range such that the decomposition can be controlled to only occur sufficiently close to the substrate. Decomposition of the dopant transfer compound at too great a distance from the substrate results in the deposition of the dopant onto the reactor walls and a consequential contamination of the reactor system. Unless the reactor is clean of such deposits, the improperly deposited dopants will slowly evaporate during subsequent epitaxial growths and unpredictably dope the layers. Thus, these deposits act as delayed dopant sources that, consequently, also give rise to the memory-effect phenomenon.

Finally, the dopant transport compound itself must be such that, following decomposition, no contaminating reaction product is produced. The non-dopant fraction of the compound must be either non-reactive or particularly reactive with the transport compound carrier gas (typically hydrogen) and highly volatile so as to be easily removed from the vicinity of the substrate without contaminating either the substrate or the reactor system.

The delayed doping of MOCVD grown epitaxial layers may also occur in the absence of dopant transport compound condensation and the improper deposition of a dopant within the reactor system. During the early stages of the deposition of an epitaxial layer, a previously deposited epitaxial layer may also act as a delayed-dopant source. The dopants in the underlying layer, proportional to their particular volatility, will outdiffuse into the growing epitaxial layer. Thus, the two epitaxial layers, as well as the junction between them will be unpredictably graded or compensated, depending on the relative conductivity types of the two layers.

## Summary of the invention

The general purpose of the present invention is to provide a metal-organic transport compound that permits the MOCVD growth of readily reproducible beryllium doped compound or alloy semiconductor epitaxial layers. This is attained in the present invention by the process claimed in claim 1.

An advantage of the present invention is that there is no significant contamination of either the substrate or the reactor system through the use of diethylberyllium as the transport compound.

Another advantage of the present invention is that beryllium, deposited as a consequence of the decomposition of diethylberyllium, has a high physical and electrical incorporation efficiency.

A further advantage of the present invention is that diethylberyllium has a high vapor pressure, while beryllium has a relatively low vapor pressure that, in combination, effectively prevents the occurrence of delayed doping.

Still another advantage of the present invention is that diethylberyllium can also be used to provide elemental beryllium in the growth of beryllium alloy compound semiconductor material epitaxial layers.

Other attendant advantages of the invention will become apparent and readily appreciated as the same becomes better understood by reference to the following detailed description.

## Detailed description of the invention

For clarity, the present invention will be discussed below and in the accompanying examples as providing a p-type dopant in a III—V compound semiconductor epitaxial layer, particularly GaAs grown by MOCVD. The true scope of the present invention, however, is broader. Not only can the present invention also be utilized advantageously in the MOCVD growth of epitaxial layers comprised of III—V compound alloy semiconductor materials, but also of the various desirable III—VI, II—V and II—VI compound and compound alloy semiconductor materials, including $In_xTe_y$, $In_xSe_y$.

The present invention can be utilized advantageously in substantially all conventional MOCVD reactor systems including those shown in U.S. Patents 4,108,106, 3,916,822, 3,704,987 and 3,633,537.

In accordance with the present invention, diethylberyllium $[(C_2H_3)_2Be]$ or DEB, an organo-metallic compound, is effectively utilized as a dopant transport compound to provide for the beryllium doping of an epitaxial layer of a compound semiconductor material, such as GaAs, grown in a conventional MOCVD reactor system. In order to control the mole fraction of the transport compound that is picked up by the carrier gas, preferably hydrogen, and conveyed thereby into the reaction chamber, a reservoir of DEB is maintained in a typical bubbler vessel. The mole fraction of the DEB transport compound picked up by the carrier gas from this DEB source can be controlled in two ways. The first is to utilize different methods of enabling the DEB to be picked up by the carrier gas. These methods include simply bubbling the carrier gas through the DEB source. Another is to pass the carrier gas over the surface of the DEB within the bubbler vessel. In this case, the reduced DEB surface area presented to the carrier gas flow naturally results in a lower mole fraction pick-up of the DEB. Still another method is to pass the carrier gas by the outlet of a capillary flow limited DEB effusion source or, more simply, by bypassing the inlet and outlet tubes of a conventional bubbler containing DEB such that it effectively acts as an effusion source. Naturally, the mole fraction pick-up of DEB from an effusion source will be the lowest of these three methods.

The second way of controlling the mole fraction of the DEB picked up is to significantly reduce the temperature of the DEB, thereby lowering its vapor pressure. A lesser amount of DEB is inherently picked by the carrier gas as compared to the identical situation where the DEB is maintained at a higher temperature. Naturally, temperature/vapor pressure control can be employed in combination with the various DEB bubbler configuration pick-up methods so as to permit the desired mole fraction of DEB to be carried into the reactor chamber.

A factor of great importance in the accurate utilization of organo-metallics is the substantial elimination of the memory-effect phenomenon. As explained above, the memory-effect phenomenon results in large part from condensation of the organo-metallic compound within the reactor system and from the improper deposition of the dopant onto the inner surfaces of the reactor chamber instead of the growing surface of the epitaxial layer. Condensation of the organometallic is avoided by maintaining the reactor system as a whole and, in particular, the inner surfaces of the gas lines and reactor chamber at a temperature above that of the vapor phase transport organo-metallic compound. In the case of the present invention, the gas line and the reaction chamber inner surfaces can be maintained conveniently at approximately room temperature by stipulating that the DEB source be maintained at a temperature below approximately 27°C and preferably within the approximate temperature range of 25° to −100°C. At 27°C, the vapor pressure of DEB is 1333 Pa (1 mm Hg=133 Pa) at normal atmospheric pressure. In the context of MOCVD reactor systems, this is considered to be a high vapor pressure, though sufficiently controllable in terms of obtaining a dopant transport compound/carrier gas mixture having a useful mole fraction of DEB. However, the DEB source vapor pressure can be substantially reduced in an accurately controllable manner by progressively reducing the temperature of the DEB source down to approximately 12°C, the freezing point of DEB. Once the DEB source has frozen, its vapor pressure can be further controllably reduced, though at a lower rate, by continuing to reduce the temperature of the DEB source. As a practical matter, no further reduction in the DEB vapor pressure need be realized by reducing the DEB source temperature beyond approximately −100°C. The temperature range of 27° to −100°C corresponds to a broad range of vapor pressures. However, the vapor pressure of the DEB source can be further reduced by progressively reducing the DEB source temperature down to −273°C. Thus, the preferred DEB source temperature range corresponds to a broad vapor pressure range that, in combination with the various bubbler configurations, permits the easy and accurately controllable carrier gas pick-up of a desired mole fraction of DEB.

The proper deposition of the dopant fraction of the transport compound on the epitaxial growth surface of the substrate can be effectively enhanced by stipulating that the transport compound decomposition temperature range be sufficiently restricted and below the substrate temperature such that the transport compound decomposes only in the reactor chamber and is fully decomposed by the time it arrives in close proximity with the epitaxial growth surface. Naturally, the decomposition substrate must be maintained at a temperature that is below the temperature that will in any significant way disturb the substrate and any previously deposited epitaxial layer. In the case of the present invention, the decomposition temperature of DEB occurs in a very restricted temperature range centered about approximately 100°C. By maintaining the substrate above this temperature range, the decomposition of the DEB occurs in sufficiently close proximity to the epitaxial growth surface such that substantially all of the beryllium dopant is properly deposited on the epitaxial growth surface. For the growth of GaAs epitaxial layers, the substrate is generally maintained between 600° and 900°C so as to enable the appropriate decomposition of the trimethylgallium and arsine. Consequently, a preferred substrate temperature is approximately 700°C.

Beryllium that is improperly deposited on the walls of the reaction chamber is effectively precluded from acting as a delayed-dopant due to its exceptionally low vapor pressure; lower, in fact, than any of the elements that are conventionally utilized as p-type dopants in MOCVD grown GaAs epitaxial layers. Any improperly deposited beryllium simply fails to evaporate from the reactor surface at any significant rate. There is therefore no observable memory-effect phenomenon due to the use of DEB to provide beryllium as a dopant.

The organic components of the decomposition reaction must also not act as a source of contamination to either the reactor system or the substrate and any epitaxially grown layers present thereon. In the case of the epitaxial growth of a beryllium-doped gallium arsenide epitaxial layer utilizing a hydrogen carrier gas and DEB, trimethylgallium (TMG) and arsine as the sources of the beryllium, gallium and arsenic, respectively, the various organic decomposition fractions interreact to directly form ethane and excess hydrogen. Ethane and hydrogen are both highly volatile and easily removable from the reactor system without contaminating the reactor chamber, epitaxial layer or the substrate.

Following the controlled decomposition of DEB along with trimethylgallium and arsine, beryllium is deposited onto the growth surface where it is both physically and electrically incorporated into the growing GaAs epitaxial layer. The physical incorporation of beryllium as a dopant into an epitaxial layer is generally limited to approximately the solid solubility of beryllium in the particular compound semiconductor material. For GaAs, the limit of beryllium solid solubility is between approximately $1\times10^{20}$ and $1\times10^{21}$ atoms/$cm^3$. Physical incorporation of beryllium at higher concentrations, though obtainable, is subject to the time and temperature dependent process of solid precipitation of beryllium within the epitaxial layer. The physical incorporation of beryllium at concentrations of approximately $10^{20}$ atoms/$cm^3$ or less is not limited to any significant degree by surface kinetic effects at the growth surface of the epitaxial layer which, as when using other deposition techniques such as molecular beam epitaxy (MBE), results in the surface

pile-up phenomenon. Consequently, the physical incorporation efficiency of beryllium is high throughout the conventional dopant concentration range of approximately $1\times10^{15}$ to $10^{20}$ atoms/$cm^3$.

The electrical incorporation efficiency of beryllium as a dopant is also quite high throughout the conventional range of dopant concentrations. Beryllium is a substantially non-amphoteric dopant species, particularly in GaAs, thereby resulting in very low self-compensation. Further, due to the uniform physical incorporation of beryllium, the electrical characteristics of a doped epitaxial layer are non-anomalous throughout the range of conventional doping concentrations.

The actual concentration of beryllium in an MOCVD grown epitaxial layer is largely dependent on a number of conventional reactor system variables that are all easily controllable. As discussed above, a principal variable is the mole fraction of DEB that is picked up by the carrier gas. The bubbler temperature, and therefore the vapor pressure of the DEB, and the particular method by which the carrier gas is passed by or through the DEB are directly controllable. Another system variable is the flow rate of the DEB bearing carrier gas into the reactor chamber. The higher the flow rate, the greater the quantity of DEB that is delivered into close proximity with the substrate and, consequentially, the higher the dopant concentration realized. Carrier gas flow rate is easily controllable by means of a mass flow control valve in the carrier gas feed line prior to the bubbler as typically provided in conventional MOCVD reactor systems. Finally, the growth rate of the epitaxial layer itself, as a system variable, directly impacts the concentration of beryllium incorporated into the epitaxial layer. For any given set of system variables, increasing the growth rate of the epitaxial layer will directly decrease the concentration of beryllium incorporated therein. Naturally, the growth rate of the epitaxial layer itself is dependent on, in the case of GaAs, the mole fractions of trimethylgallium and arsine present in the carrier gas, the corresponding carrier gas flow rate, and the temperature of the substrate.

The various parameters described above are readily determined for conventional MOCVD reactors and only require simple and ordinary experimentation. The Examples below illustrate that for such a reactor, beryllium dopant concentration is easily and reproducibly controlled over a substantial range.

Example 1

A GaAs epitaxial layer having a beryllium dopant concentration of approximately $1.6\times10^{20}$ atoms/$cm^3$ and uniform physical and electrical qualities were grown on the surface of a GaAs substrate maintained at a temperature of approximately 700°C. Trimethylgallium, picked up by passing hydrogen through a bubbler containing liquid trimethylgallium at a temperature of −12°C at a flow rate of 23 $cm^3$/min, mixed with arsine, provided at a flow rate of 0.8 $cm^3$/min, and hydrogen, provided at a flow rate of 2,900 $cm^3$/min, was passed into an atmospheric pressure MOCVD reactor chamber to obtain an epitaxial growth rate of 0.18 µm/min. Diethylberyllium, picked up by bubbling hydrogen at a flow rate of 400 $cm^3$/min through a conventional bubbler with the diethylberyllium contained therein being maintained at a temperature of approximately 27°C, was further combined with the above mixture and passed into the reactor chamber, thereby providing for the epitaxial growth of a beryllium doped p-type GaAs layer.

Example 2

The same growth conditions were used as in the previous Example except that the hydrogen flow rate through the diethylberyllium bubbler was reduced to 20 $cm^3$/min, the substrate temperature was reduced to 650°C, and the epitaxial growth rate was increased to 0.2 µm/$cm^3$ to obtain a p-type GaAs epitaxial layer having a beryllium dopant concentration of $3.1\times10^{19}$ atoms/$cm^3$.

By progressively reducing the diethylberyllium source temperature down to approximately −100°C, reducing the hydrogen flow rate, and configuring the diethylberyllium bubbler as an effusion source, the MOCVD growth of epitaxial layers of uniform physical and electrical qualities having beryllium dopant concentration significantly below $1\times10^{16}$ atoms/$cm^3$ can be reasonably obtained.

Thus, an organo-metallic compound suitable for providing elemental beryllium as a dopant in a semiconductor epitaxial layer grown in a MOCVD reactor system has been described. The use of the present invention in conjunction with the MOCVD growth of GaAs epitaxial layers is merely illustrative of the preferred embodiment of the invention. Obviously, in light of the above teachings, the present invention can be utilized otherwise than as specifically described.

**Claims**

1. Process of epitaxially depositing a layer of a semiconductor material including a given elemental species in a metal-organic chemical vapor deposition (MOCVD) system including a reactor chamber onto a substrate maintained within said reactor chamber, characterized in that said elemental species is obtained from the decomposition of vapor phase diethylberyllium.

2. The process of Claim 1 being further characterized in that said elemental species acts as a dopant to provide said layer with a given conductivity type.

3. The process of Claim 2 wherein said semiconductor material comprises a Group III—V compound and said given conductivity type is p-type.

4. The process of Claim 1, 2 or 3, further characterized in that said diethylberyllium is conveyed into said reactor chamber by a carrier gas,

the pick-up of said diethylberyllium from a source of diethylberyllium by said carrier gas being dependent on the vapor pressure of said diethylberyllium source, the vapor pressure being variably controlled by controlling the temperature of said diethylberyllium source within the range of approximately 27° and −100°C.

5. The process of Claim 4 wherein the temperature of said diethylberyllium source is controlled within the range of approximately 25° and −100°C.

6. The process of Claim 4 further characterized in that said substrate is maintained within the temperature range of approximately 400° to 900°C during the epitaxial deposition of said layer.

7. The process of Claim 6 wherein said substrate is maintained at a temperature of approximately 700°C.

**Patentansprüche**

1. Verfahren zur epitaktischen Ablagerung einer Schicht eines Halbleitermaterials, das eine bestimmte Elementenart enthält, in einem eine Reaktorkammer umfassenden System zur metallorganischchemischen Dampfablagerung (metal-organic-chemical vapour deposition MOCVD) auf einem Substrat, das in dieser Reaktorkammer gehalten wird, dadurch gekennzeichnet, daß die Elementenart durch Zersetzung der Dampfphase von Diäthylberyllium erhalten wird.

2. Verfahren nach Anspruch 1, dadurch gekennzeichnet, daß die Elementenart als Doterungsmittel dient, um der Schicht einen bestimmten Leitfähigkeitstyp zu geben.

3. Verfahren nach Anspruch 2, worin das Halbleitermaterial eine III—V-Gruppen-Verbindung aufweist und der bestimmte Leitfähigkeitstyp vom p-Typ ist.

4. Verfahren nach Anspruch 1, 2 oder 3, dadurch gekennzeichnet, daß das Diäthylberyllium durch ein Trägergas in die Reaktorkammer befördert wird, wobei die Aufnahme das Diäthylberylliums durch das Trägergas aus einer Diäthylberyllium-Quelle von dem Dampfdruck der Diäthylberyllium-Quelle abhängt, der durch Regelung der Temperatur der Diäthylberyllium-Quelle in einem Bereich von ungefähr 27°C und −100°C variabel eingestellt wird.

5. Verfahren nach Anspruch 4, wobei die Temperatur der Diäthylberyllium-Quelle in einem Bereich von ungefähr 25°C und −100°C geregelt wird.

6. Verfahren nach Anspruch 4, dadurch gekennzeichnet, daß das Substrat während der epitaktischen Ablagerung der Schicht in einem Temperaturbereich von ungefähr 400°C bis 900°C gehalten wird.

7. Verfahren nach Anspruch 6, wobei das Substrat auf einer Temperatur von ungefähr 700°C gehalten wird.

**Revendications**

1. Procédé de déposition épitaxiale d'une couche d'une matière semiconductrice contenant une espèce élémentaire donnée dans un système de déposition chimique en phase vapeur d'un composé organométallique (DCVOM), comprenant une chambre de réaction, sur un substrat se trouvant à l'intérieur de ladite chambre, caractérisé en ce que ladite espèce élémentaire provient de la décomposition de diéthylbéryllium en phase vapeur.

2. Procédé suivant la revendication 1, caractérisé en outre en ce que l'espèce élémentaire agit comme un dopant en vue de doter ladite couche d'une conductivité de type donné.

3. Procédé suivant la revendication 2, dans lequel la matière semiconductrice comprend un composé des Groupes III—V et le type de conductivité donné est le type p.

4. Procédé suivant la revendication 1, 2 ou 3, caractérisé en outre en ce que le diéthylbéryllium est transporté dans ladite chambre de réaction par un gaz d'entraînement, le prélèvement du diéthylbéryllium d'une source de ce composé par le gaz d'entraînement étant sous la dépendance de la pression de vapeur de ladite source, qui varie sous l'influence du réglage de la température de ladite source de diéthylbéryllium dans un intervalle d'environ 27 à −100°C.

5. Procédé suivant la revendication 4, dans lequel la température de la source de diéthylbéryllium est réglée dans l'intervalle d'environ 25 à −100°C.

6. Procédé suivant la revendication 4, caractérisé en outre en ce que le substrat est maintenu dans la plage de température d'environ 400 à 900°C pendant la déposition épitaxiale de ladite couche.

7. Procédé suivant la revendication 6, dans lequel le substrat est maintenu à une température d'environ 700°C.